(19)

Europäisches
Patentamt
European
Patent Office
Office européen
des brevets

(11) **EP 2 224 505 A2**

(12) **EUROPEAN PATENT APPLICATION**

(43) Date of publication:
**01.09.2010 Bulletin 2010/35**

(51) Int Cl.:
**H01L 35/16** *(2006.01)*

(21) Application number: **10000264.1**

(22) Date of filing: **13.01.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **14.01.2009 KR 20090002995**

(71) Applicant: **Industry-academic Cooperation Foundation, Yonsei University
Seoul 120-749 (KR)**

(72) Inventors:
• **Lee, Woo Young
  Seoul 121-250 (KR)**

• **Ham, Jin Lee
  Seoul 158-752 (KR)**
• **Lee, Seung Hyun
  Incheon 403-784 (KR)**
• **Roh, Jong Wook
  Kyunggi-do, 448-130 (KR)**
• **Kim, Hyun Su
  Seoul, 142-109 (KR)**
• **Kim, Woo Chul
  Seoul, 135-270 (KR)**

(74) Representative: **Verscht, Thomas Kurt Albert
Josephsburgstrasse 88 A
81673 München (DE)**

(54) **Thermoelectric nanowire and method of manufacturing the same**

(57)    A thermoelectric nanowire and a method of manufacturing the same, in which an oxide layer and a thermoelectric material layer, both of which have different thermal expansion coefficients, are stacked on a substrate, and a single crystal thermoelectric nanowire is grown from a thermoelectric material using the compressive stress caused by the difference between the thermal expansion coefficients. The method includes preparing a substrate on which an oxide layer is formed, forming a plurality of nanoparticles, each of which includes aluminum (Al), silver (Ag), iron (Fe) or oxides thereof, on the oxide layer, forming a thermoelectric material thin film, which has thermoelectric properties, above the oxide layer so as to include the nanoparticles formed on the oxide layer, heat-treating the substrate having the thermoelectric material thin film to grow the thermoelectric nanowire containing the nanoparticles, and cooling the substrate at room temperature after the heat-treatment.

FIG. 1

## Description

## CROSS REFERENCE TO RELATED APPLICATION

The present application claims priority from Korean Patent Application Number 10-2009-2995 filed on January 14, 2009, the entire contents of which application is incorporated herein for all purposes by this reference.

## BACKGROUND OF THE INVENTION

## Field of the Invention

The present invention relates, in general, to a thermoelectric nanowire and, more particularly, to a thermoelectric nanowire and a method of manufacturing the same, in which an oxide layer and a thermoelectric material layer, which have different thermal expansion coefficients, are stacked on a substrate, and a single crystal thermoelectric nanowire is grown from a thermoelectric material using compressive stress caused by the difference between the thermal expansion coefficients.

## Description of the Related Art

As is generally known in the art, semimetals such as bismuth (Bi), antimony (Sb), arsenic (As), silicon (Si), and germanium (Ge) exhibit the properties of both metals and non-metals, and are used for electric devices either in a pure state or in alloy form. These semimetals are arousing particular interest as thermoelectric materials when in the form of semiconductor alloys. Such thermoelectric materials have low thermal conductivity and high electrical conductivity, and have been the object of intensive study recently. For example, an alloy of Bi and tellurium (Te), $Bi_xTe_{1-x}$, is heavy and has a small spring coefficient because of van der Waals bonding between Bi and Te and the covalent bond between Te and Te, thus imparting it with low thermal conductivity. For this reason, the Bi-Te alloy can show a high figure of merit, ZT, which indicates the thermoelectric properties of thermoelectric materials, and thus is currently used as a thermoelectric material.

Further, when this alloy, $Bi_xTe_{1-x}$, is formed into a nanowire, its electron density of state can be controlled. When the shape and peak position of this electron density of state are matched to a Fermi level, the Seebeck coefficient, which influences the thermoelectric effect, can be regulated. Further, the motion of electrons is increased by the quantum confinement effect, and thus the electrical conductivity can be kept high. As such, the nanowire of $Bi_xTe_{1-x}$ can overcome the limitations of bulk thermoelectric material, and can exhibit a relatively high ZT value.

Meanwhile, to obtain high thermoelectric efficiency, it is necessary to manufacture a single crystal thermoelectric nanowire. However, since it is difficult to form thermoelectric materials known in nature into a single crystal structure, the growth of the thermoelectric nanowire is restricted, and the method of growing the single crystal thermoelectric nanowire is not yet widely known.

Generally, since the thermoelectric nanowire is grown as an alloy rather than as a pure metal, a method of growing the thermoelectric nanowire using a solvent in which respective materials are dissolved is mainly used. This method may include a template-assisted method, a solution-phase method, a pressure injection method, or the like.

Among them, the template-assisted method has a disadvantage in that it is not easy to prepare a template, and the other methods have a disadvantage in that complicated process is inevitably entailed, for instance in that a starting material is required. In addition, for a single nanowire element process, it is essential to properly remove the template and chemical materials remaining on the nanowire. Due to a low aspect ratio, it is difficult to form a variety of patterns in the single nanowire element process. In particular, the thermoelectric nanowire grown through this known method has a polycrystalline structure, and thus it has low thermoelectric efficiency and limitations in realizing the inherent properties of single crystal thermoelectric nanowires.

In consideration of this aspect, the applicant of the present invention has already filed patent applications (Korean Patent Application Nos. 10-2006-137069 and 10-2007-51236) pertaining to technology for growing single crystal thermoelectric nanowires. Furthermore, in the related art, technology for growing single crystal thermoelectric nanowires, which is capable of remarkably improving thermoelectric efficiency, has been continuously required of late.

The information disclosed in this Background of the Invention section is only for the enhancement of understanding of the background of the invention and should not be taken as an acknowledgment or any form of suggestion that this information forms a prior art that would already be known to a person skilled in the art.

## BRIEF SUMMARY OF THE INVENTION

Accordingly, the inventors have studied a method of reducing thermal conductivity to enhance thermoelectric efficiency beyond that of a conventional thermoelectric nanowire. As a result, they have discovered that, when nanoparticles having reduced thermal conductivity are included in the thermoelectric nanowire when the thermoelectric nanowire is grown, it is possible to reduce the thermal conductivity of the thermoelectric nanowire to enhance its thermoelectric efficiency using a simple method which does not require a template manufacturing process or a catalyst forming process, as in the prior art, the introduction of a starting material, or a complicated manufacturing process. The present invention is based on this discovery.

Aspects of the present invention provide a method of manufacturing a thermoelectric nanowire that enables the growth of the thermoelectric nanowire including nanoparticles which reduce thermal conductivity to thus enhance the thermoelectric efficiency of the thermoelectric nanowire.

Also provided is a thermoelectric nanowire manufactured by this manufacturing method.

According to one aspect of the present invention, a method of manufacturing a thermoelectric nanowire is provided. The method may include processes of: preparing a substrate on which an oxide layer is formed; forming a plurality of nanoparticles on the oxide layer, each nanoparticle including aluminum (Al), silver (Ag), iron (Fe) or oxides thereof; forming a thermoelectric material thin film above the oxide layer so as to include the nanoparticles formed on the oxide layer, the thermoelectric material thin film having thermoelectric properties; heat-treating the substrate having the thermoelectric material thin film to thus grow the thermoelectric nanowire containing the nanoparticles; and cooling the substrate at room temperature after the heat-treating process.

Here, in the heat-treating process, the substrate, the oxide layer, and the thermoelectric material thin film may have different thermal expansion coefficients, and the thermoelectric material thin film, which undergoes high volume expansion, may be subjected to compressive stress by the oxide layer, which undergoes low volume expansion.

Further, the thermoelectric nanowire may be grown from the thermoelectric material thin film using the compressive stress while the nanoparticles covering the oxide layer are diffused thereinto.

Also, the thermal expansion coefficient of the thermoelectric material thin film may have a difference ranging from $2 \times 10^{-6}/°C$ to $20 \times 10^{-6}/°C$ when compared to that of the oxide layer, and may be greater than that of the oxide layer.

Meanwhile, the thermoelectric material may have a composition that includes one selected from bismuth (Bi), a Bi-selenium (Se) alloy, a Bi-tellurium (Te) alloy, a lead (Pb)-Te alloy, a Bi-antimony (Sb) alloy, a Bi-Sb-Te alloy, and a Bi-Se-Te alloy.

Further, in the cooling process, the substrate, the oxide layer, and the thermoelectric material thin film may have different thermal expansion coefficients, and the thermoelectric material thin film, which undergoes high volume reduction, may be subjected to tensile stress by the oxide layer, which undergoes low volume reduction.

Also, the oxide layer may have a composition that includes one selected from $SiO_2$, BeO, and $Mg_2Al_4Si_5O_{18}$, and has a thickness ranging from 3,000 Å to 5,000 Å.

The thermoelectric material thin film may have a thickness ranging from 10 nm to 4 $\mu$m.

Further, in the heat-treating process, the substrate may be heat-treated at a temperature ranging from 100°C to 1000°c: for a period ranging from 1 hour to 15 hours.

Also, the thermoelectric nanowire may have a single crystal structure and a diameter ranging from 50 nm to 1,000 nm when grown.

Furthermore, each nanoparticle may have a diameter ranging from 1 nm to 20 nm.

According to another aspect of the present invention, a thermoelectric nanowire manufactured according to the method mentioned above is provided.

According to yet another aspect of the present invention, there is provided a thermoelectric nanowire element, which may include a thermoelectric nanowire composed of one selected from among Bi, a Bi-Se alloy, a Bi-Te alloy, a Fb-Te alloy, a Bi-Sb alloy, a Bi-Sb-Te alloy, and a Bi-Se-Te alloy; and a plurality of nanoparticles including Al, Ag, Fe or oxides thereof, the nanoparticles contained in the thermoelectric nanowire.

Here, the thermoelectric nanowire may have a single crystal structure and a diameter ranging from 50 nm to 1,000 nm when grown. Further, the nanoparticles may each have a diameter ranging from 1 nm to 20 nm.

According to exemplary embodiments of the present invention, to grow the single crystal thermoelectric nanowire, a typical nanowire synthesis process, such as a template manufacturing process or a catalyst forming process, is not required, unlike the prior art. Further, a single crystal thermoelectric nanowire having excellent crystallinity can be grown without introducing a starting material or a heterogeneous material and without a change in the state of the thermoelectric material.

In addition, since the nanoparticles, which reduce the thermal conductivity, are included in the thermoelectric nanowire, the thermoelectric efficiency of the thermoelectric nanowire can be improved due to the reduction in thermal conductivity.

The methods and apparatuses of the present invention have other features and advantages which will be apparent from, or are set forth in more detail in, the accompanying drawings, which are incorporated herein, and the following Detailed Description of the Invention, which together serve to explain certain principles of the present invention.

## BRIEF DESCRIPTION OF THE DRAWINGS

FIG. 1 schematically illustrates a process of manufacturing a thermoelectric nanowire according to an exemplary embodiment of the present invention;

FIG. 2 is a schematic view illustrating an apparatus for manufacturing a thermoelectric nanowire according to an exemplary embodiment of the present invention;

FIG. 3 is a schematic view illustrating a process of growing a thermoelectric nanowire according to an exemplary embodiment of the present invention;

FIGS. 4 (a) and 4 (b) are a schematic view and a cross-sectional view illustrating a thermoelectric nanowire grown by a method of manufacturing a thermoelectric nanowire according to an exemplary embodiment of the present invention;

FIG. 5 is a schematic view illustrating an apparatus for forming a thermoelectric material thin film for manufacturing a thermoelectric nanowire using a co-sputtering method according to an exemplary embodiment of the present invention, as well as the thermoelectric material thin film formed by the apparatus;

FIG. 6 is a graph showing the thermal conductivity of nanoparticle-containing Bi nanowires according to an exemplary embodiment of the present invention as a function of temperature in comparison with conventional pure Bi nanowires;

FIG. 7 is a scanning electron microscope (SEM) micrograph showing the structure of a single crystal thermoelectric nanowire manufactured by a method of manufacturing a thermoelectric nanowire according to an exemplary embodiment of the present invention;

FIG. 8 is a transmission electron microscope (TEM) micrograph showing the structure of a single crystal thermoelectric nanowire manufactured by a method of manufacturing a thermoelectric nanowire according to an exemplary embodiment of the present invention; and

FIG. 9 is a micrograph showing the electron diffraction pattern of a single crystal thermoelectric nanowire manufactured by a method of manufacturing a thermoelectric nanowire according to an exemplary embodiment of the present invention.

## DETAILED DESCRIPTION OF THE INVENTION

Reference will now be made in detail to various embodiments of the present invention(s), examples of which are illustrated in the accompanying drawings and described below. While the invention(s) will be described in conjunction with exemplary embodiments, it will be understood that the present description is not intended to limit the invention(s) to those exemplary embodiments. On the contrary, the invention(s) is/are intended to cover not only the exemplary embodiments, but also various alternatives, modifications, equivalents and other embodiments that may be included within the spirit and scope of the invention as defined by the appended claims.

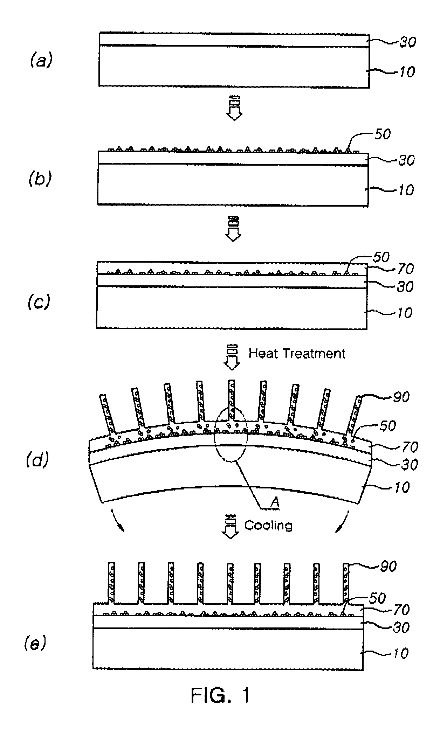

FIG. 1 schematically illustrates a process of manufacturing a thermoelectric nanowire according to an exemplary embodiment of the present invention.

Referring to FIG. 1(a), first, a substrate 10, on which an oxide layer 30 has been formed, is prepared. The oxide layer 30 may employ one selected from, for example, $SiO_2$, BeO, and $Mg_2Al_4Si_5O_{18}$. This substrate 10 preferably employs a silicon (Si) substrate having a thermally oxidized surface, i.e. a Si substrate the surface of which is subjected to thermal oxidation. Here, the oxide layer 30 formed on the substrate 10 preferably has a thickness ranging from 3,000 Å to 5,000 Å. The reason for this range is as follows. If the thickness of the oxide layer 30 formed on the substrate 10 is beyond the range of 3,000 Å to 5, 000 Å, this fails to meet the stress conditions that are required for the growth of a nanowire, and thus may restrict the growth of the nanowire.

Then, as illustrated in FIG. 1(b), a plurality of nanoparticles 50, which is made up of aluminum (Al), silver (Ag), iron (Fe), or oxides thereof, is formed on the oxide layer 30. For example, nanoparticles 50 of Al, Ag, Fe, $Al_2O_3$, AgO, $Fe_3O_4$, or the like are preferably formed. The nanoparticles 50 may be formed by, for instance, adding the nanoparticles to an ethanol solution and applying them to the surface of the oxide layer 30 using spin coating. Afterwards, the ethanol solution is evaporated, leaving only the nanoparticles 50 behind.

Subsequently, as illustrated in FIG. 1(c), a thin film 70 is formed above the oxide layer 30 using a thermoelectric material so as to include the nanoparticles 50 formed on the oxide layer 30. Here, the thermoelectric material is a material having thermoelectric properties corresponding to the Seebeck effect, by which a voltage is produced by the temperature difference between opposite ends of a material, and the Peltier effect, by which, when an electric current flows between opposite ends of a material, one surface generates heat while the other surface absorbs heat. This thermoelectric material may have a composition that includes one or an alloy of at least one selected from metals having high electrical conductivity, such as bismuth (Bi), tellurium (Te), selenium (Se), lead (Pb), antimony (Sb), tin (Sn), and so on. For example, the thermoelectric material may have a composition that includes Bi, or Bi-Se, Bi-Te, Pb-Te, Bi-Sb, Bi-Sb-Te, or Bi-Se-Te alloy. Here, among these alloys, for example, the "Bi-Se alloy" refers to $Bi_2Se$, the "Bi-Te alloy" refers to $Bi_2Te_3$, and the "Pb-Te alloy" refers to PbTe or $Pb_2Te_3$. Here, the substrate 10, the oxide layer 30, and the thermoelectric material thin film 70 preferably have different thermal expansion coefficients. In an exemplary embodiment of the present invention, this thermoelectric material thin film 70 may be formed through various processes including typical sputtering or co-sputtering.

The composition of this thermoelectric material thin film 70 may be adjusted. As one example, the composition of the $Bi_2Te_3$ thin film may depend on the power applied when the materials, Bi and Te, are deposited. The composition of the $Bi_2Te_3$ thin film may be adjusted in this way. Further, when an attempt is made to grow $Bi_2Te_3$ nanowires, growth is made possible by adjusting the composition of the $Bi_2Te_3$ thin film.

Herein, the thermoelectric material thin film 70 preferably has a thickness ranging from 10 nm to 4 $\mu$m. The reason for this range is as follows. If the thickness of the thermoelectric material thin film 70 is less than 10 nm, the amount of material required for the growth of the nanowires is not sufficient, making it difficult to grow the nanowires. In contrast, if the thickness of the thermoelectric material thin film 70 is greater than 4 $\mu$m, the thermal expansion difference between the oxide layer 30 and the thermoelectric material thin film 70 is not suitable for the range required when the nanowires are grown, and thus the growth of the nanowires is not properly achieved.

Meanwhile, in an exemplary embodiment of the present invention, although not illustrated, a passivation layer, for instance, an oxide layer of $Bi_2O_3$, may be selectively formed on the thermoelectric material thin film 70.

Continuously, as illustrated in FIG. 1(d), the substrate 10, in which the thermoelectric material thin film 70 is formed on the oxide layer 30, is placed in a reactor, and is then subjected to heat treatment. Here, an apparatus for manufacturing the single crystal thermoelectric nanowires, i.e. a manufacturing apparatus that includes the reactor for heat-treating the substrate 10 in which the thermoelectric material thin film 70 is formed above the oxide layer 30, will be described with reference to a configuration and heat-treating process thereof as follows.

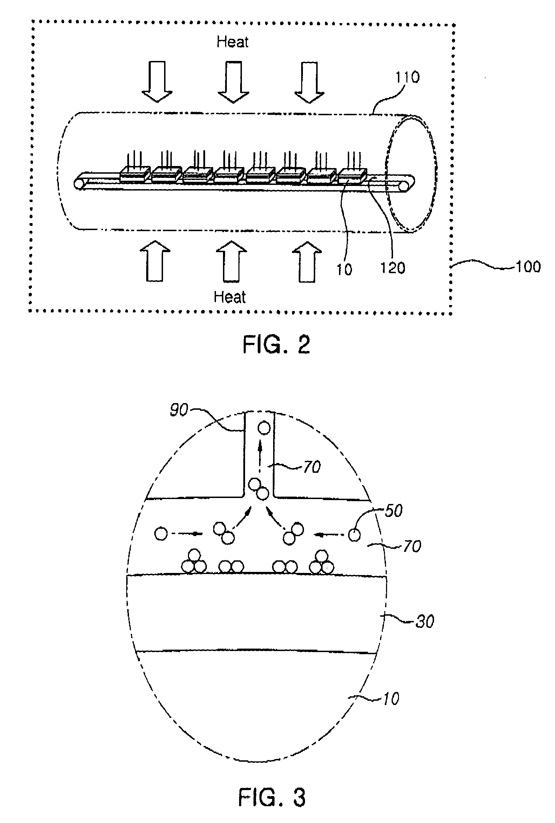

FIG. 2 is a schematic view illustrating an apparatus for manufacturing a thermoelectric nanowire according to an exemplary embodiment of the present invention.

Referring to FIG. 2, an apparatus for manufacturing a thermoelectric nanowire generally includes a reactor 100, a quartz tube 110 disposed in the reactor 100, and an alumina boat 120 disposed in the quartz tube 110. Although not illustrated, the reactor 100 is configured such that, a heater (not shown) is provided to heat the quartz tube 110 and simultaneously heat the alumina boat located in the quartz tube 110. In this case, the heating temperature may be adjusted using a controller (not shown). In addition, a vacuum pump (not shown) is located at the right-hand end of the quartz tube 110 to produce a vacuum in the quartz tube 110.

The substrate 10, in which the thermoelectric material thin film 70 is formed above the oxide layer 30 so as to include the nanoparticles 50 formed on the oxide layer 30, is placed in the alumina boat 120. In detail, after the substrate 10, in which the thermoelectric material thin film 70 is formed above the oxide layer 30, is mounted on the alumina boat 120 in the quartz tube 110, the alumina boat 120 is heated by the heat of the heater (not shown), and the substrate 10 is heated simultaneously. Herein, the reactor 100 is preferably maintained at a pressure of about $10^{-7}$ Torr, because the pressure of about $10^{-7}$ Torr makes it possible to prevent oxidation of the growing nanowires to thereby allow the nanowires to be grown with high crystallinity.

In this manner, by heating the substrate 10 mounted on the alumina boat 120, as illustrated in FIG. 1(d), the internal temperature begins to increase during the heat treatment, and thus compressive stress is applied to the thermoelectric material thin film 70 of the substrate 10. To be more specific, since the substrate 10, the oxide layer 30, and the thermoelectric material thin film 70 have different thermal expansion coefficients, the thermoelectric material thin film 70, which undergoes high volume expansion due to a high thermal expansion coefficient of about $19 \times 10^{-6}$/°C, is subjected to compressive stress by the oxide layer 30, which undergoes low volume expansion due to the relatively low thermal expansion coefficient of about $0.5 \times 10^{-6}$/°C during the heat treatment. When the heat-treatment temperature is increased, the lower oxide layer 30 is expanded less than the upper thermoelectric material thin film 70. This expansion difference acts as a force that inhibits the expansion of the thermoelectric material thin film 70, so that the compressive stress is applied to the thermoelectric material thin film 70. For this reason, as illustrated in FIG. 3, the thermoelectric material thin film 70 protrudes from its surface and thus grows in the form of the nanowires 90.

Herein, since the growth of the nanowires 90 is induced by compressive stress, the thermal expansion coefficient difference between the thermoelectric material thin film 70 and the oxide layer 30 is preferably maintained greater than a predetermined value. As the thermal expansion coefficient difference increases, the compressive stress can be easily induced. The thermal expansion coefficient difference preferably ranges from $2 \times 10^{-6}$/°C to $20 \times 10^{-6}$/°C. If the thermal expansion coefficient difference is less than $2 \times 10^{-6}$/°C, the compressive stress is not easily applied, making the growth of the nanowires difficult. In contrast, if the thermal expansion coefficient difference is greater than $20 \times 10^{-6}$/°C, a burden resulting from an increase in the heat-treatment temperature may occur. Meanwhile, the heat-treatment temperature of the thermoelectric material thin film 70 is preferably limited within the range from 100°C to 1000°C. Further, the heat-treatment time is preferably limited within the range from 1 hour to 15 hours. As this heat-treatment time increases, the expansion of the thermoelectric material thin film 70 may further increase, thus inducing high compressive stress.

FIG. 3 is a schematic view illustrating a process of growing a thermoelectric nanowire according to an exemplary embodiment of the present invention.

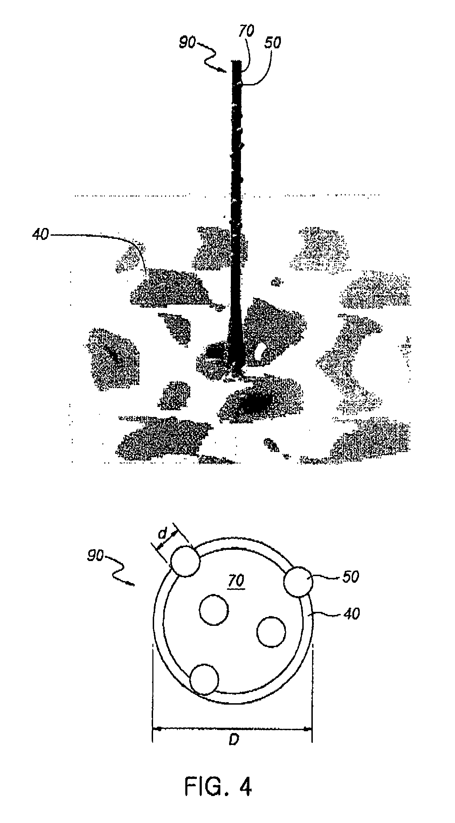

As illustrated in FIG. 3, herein, during the heat treatment as described above, the compressive stress generated by the difference in thermal expansion coefficients between the lower oxide layer 30 and the upper thermoelectric material thin film 70 causes thermoelectric material atoms to migrate from one grain to another grain through mass transportation, and thus serves as the seed for the growth of the nanowires 90. Further, cracks are generated in the rough surface of the thermoelectric material thin film 70, thereby allowing the nanowires 90 to protrude from the thermoelectric material thin film 70. Here, while the nanowires 90 are growing, the nanoparticles 50, which are included in the thermoelectric material thin film 70 and are formed on the oxide layer 30, are introduced into the nanowires 90. As illustrated in FIG. 4, the thermoelectric nanowires 90 grown in this way include the numerous nanoparticles 50. These nanoparticles 50 are preferably materials having reduced thermal conductivity. FIGS. 4 (a) and 4(b) are a schematic view and a cross-sectional view illustrating each thermoelectric nanowire grown in this way. It can be seen that the nanoparticles 50 are located in and on each nanowire 90. Preferably, the nanowire 90 has a diameter D ranging from 50 nm to 1000 nm, and the nanoparticle 50 has a diameter d ranging from 1 nm to 20 nm so that it can be included in each nanowire 90.

Subsequently, as illustrated in FIG. 1(e), after the heat treatment process is completed, the thermoelectric material thin film 70 is cooled at room temperature. In this cooling process, the oxide layer 30 and the thermoelectric material thin film 70, both of which undergo volume expansion due to the heat, tend to return to their initial state. Here, since the substrate 10, the oxide layer 30, and the thermoelectric material thin film 70 have different thermal expansion coefficients, the thermoelectric material thin film 70, the thermal expansion coefficient of which is greater than that of the oxide layer 30, shrinks faster than the oxide layer 30, generating tensile stress. When cooled, the lower oxide layer 30 shrinks much more slowly than the upper thermoelectric material thin film 70. This slow shrinkage acts as a force that inhibits the shrinkage of the thermoelectric material thin film 70, thus applying tensile stress to the thermoelectric material thin film 70. In this manner, when cooled, the thermoelectric material thin film 70, which has already undergone thermal expansion in the previous heat treatment process, is subjected to tensile stress while shrinking to return to its equilibrium state. This tensile stress stops the growth of the nanowires 90 from the thermoelectric material thin film 70.

Hereinafter, the present invention will be described in detail with reference to a test example. This test example serves merely to explain an exemplary embodiment of the present invention, and thus the present invention is not limited thereto.

Test Example

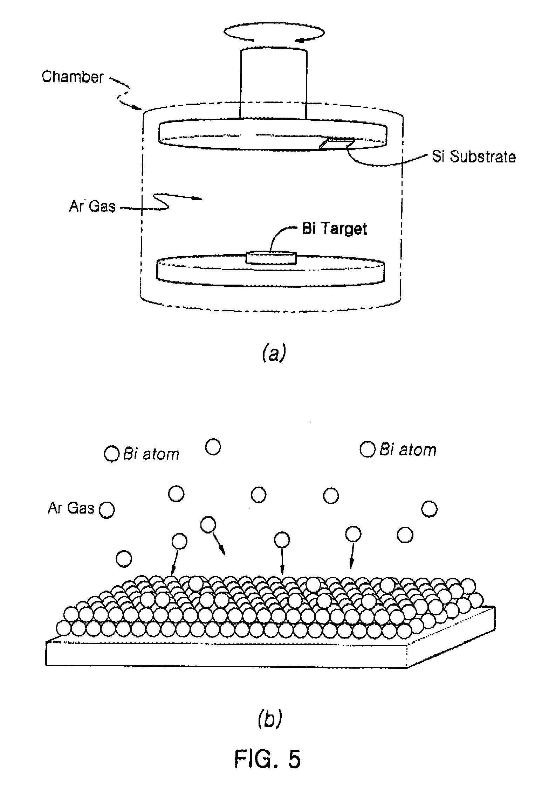

An oxide layer of $SiO_2$ was formed on a substrate to a thickness of 3000 Å, and then nanoparticles of $Al_2O_3$ were formed on the oxide layer. To this end, the $Al_2O_3$ nanoparticles were added into an ethanol solution, and were applied to the oxide layer using spin coating. Afterwards, the ethanol solution was evaporated. Then, a Bi thin film was formed above the oxide layer to a thickness of 500 Å using sputtering or co-sputtering so as to include the $Al_2O_3$ nanoparticles formed on the oxide layer. The Bi thin film was formed as illustrated in the schematic view of FIG. 5.

Afterwards, the substrate having the Bi thin film was mounted on the alumina boat of a reactor, and was heated at 250°C for 5 hours such that thermoelectric Bi nanowires were easily grown. At this time, when the Bi nanowires were grown, the $Al_2O_3$ nanoparticles formed on the oxide layer were introduced into the Bi nanowires. In detail, the Bi nanowires were grown with the introduction of the $Al_2O_3$ nanoparticles into the Bi nanowires, so that the $Al_2O_3$ nanoparticles were included in the growing Bi nanowires. As is preferable, these $Al_2O_3$ nanoparticles were located in and on each Bi nanowire.

Thereafter, after the heat treatment process, the substrate having the grown Bi nanowires was gradually cooled at room temperature. Thereby, the Bi thin film, which had expanded during the heat treatment process, shrank. At this time, tensile stress was generated, and thus the growth of the Bi nanowires was stopped. Though this process, each single crystal thermoelectric Bi nanowire, in which numerous $Al_2O_3$ nanoparticles were incorporated, was manufactured.

In the case of the thermoelectric Bi nanowires manufactured in this way, numerous $Al_2O_3$ nanoparticles capable of reducing thermal conductivity are included in each thermoelectric Bi nanowire, so that the figure of merit, ZT, which indicates the thermoelectric properties of the thermoelectric Bi nanowires, can be increased. The ZT, corresponding to the thermoelectric properties of the thermoelectric Bi nanowires, may be given by Equation 1 below:

$$ZT = \frac{S^2 \sigma T}{k} \quad \text{...... Equation 1,}$$

where S is the Seebeck coefficient, $\sigma$ is the electrical conductivity, T is the absolute temperature, and k is the thermal conductivity.

As can be seen from Equation 1 above, the value of ZT must be great in order to obtain a thermoelectric material having excellent thermoelectric efficiency. Thus, to manufacture thermoelectric nanowires having excellent thermoelectric efficiency, the electrical conductivity and the Seebeck coefficient must be great, while the thermal conductivity must be small.

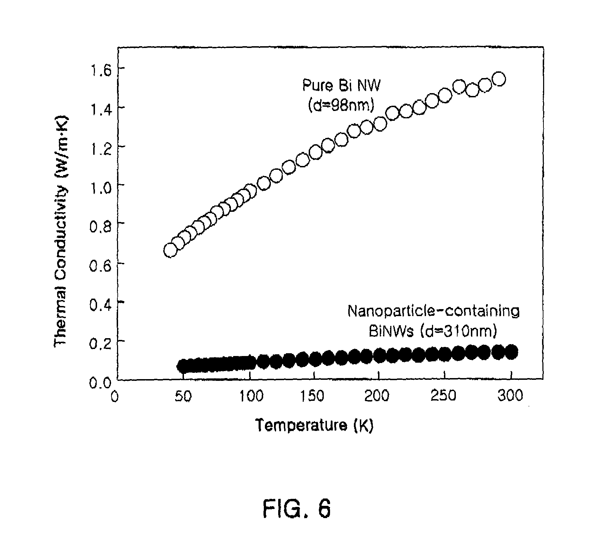

In the present invention, the thermoelectric Bi nanowires include numerous $Al_2O_3$ nanoparticles therein, so that the thermal conductivity thereof is reduced by a phonon-scattering effect, and thus the ZT value is increased. As a result, thermoelectric nanowires having excellent thermoelectric properties and efficiency can be obtained. This result is clearly shown in FIG. 6. FIG. 6 is a graph showing the thermal conductivity of nanoparticle-containing Bi nanowires of the present invention as a function of temperature in comparison with conventional pure Bi nanowires.

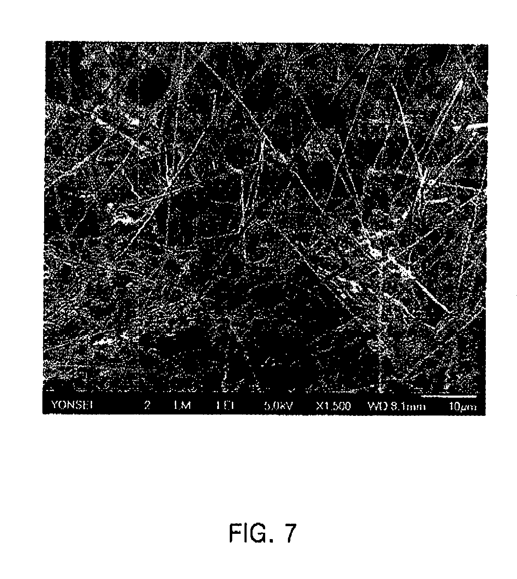

FIG. 7 is a scanning electron microscope (SEM) micrograph showing the structure of the single crystal thermoelectric nanowire manufactured in the Test Example of the present invention.

As shown in the SEM structure micrograph of FIG. 7, it can be found that the thermoelectric nanowires manufactured according to the nanowire manufacturing method of the present invention are distributed in arbitrary directions, are uniformly grown on the whole, and have high yield (due to high density). Further, it can be found that these thermoelectric nanowires have a diameter ranging from 50 nm to 100 nm and can generally be formed in a single phase. It can be seen that each single crystal thermoelectric nanowire has a length of several hundreds of microns and a diameter ranging from several nanometers to several hundreds of nanometers. When considering the diameter of each thermoelectric nanowire, each nanoparticle contained in and on each thermoelectric nanowire preferably has a diameter ranging from 1 nm to 20 nm.

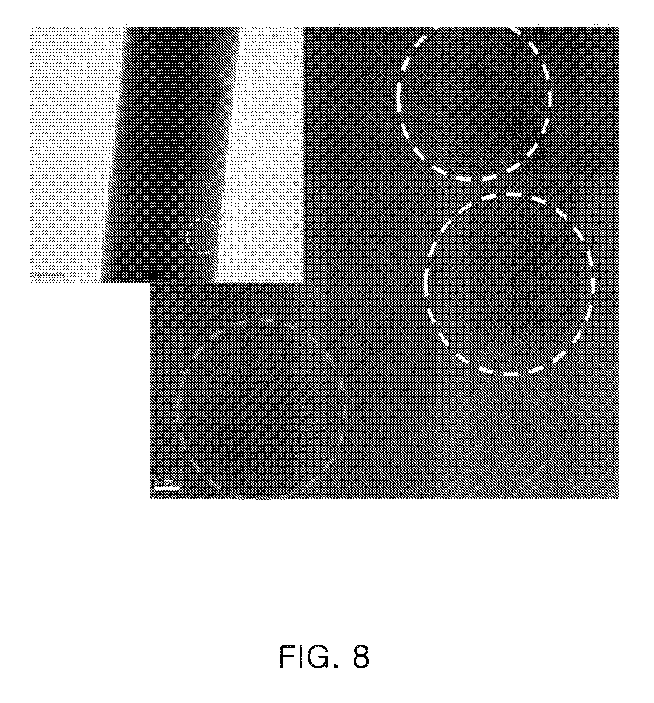

FIG. 8 is a transmission electron microscope (TEM) micrograph showing the structure of the single crystal thermoelectric nanowire manufactured in the Test Example of the present invention.

Referring to FIG. 8, it can be found from the TEM structure micrograph that numerous nanoparticles 50 are contained in each thermoelectric nanowire 90. This result shows that, when the nanowires 90 are grown from the thermoelectric material thin film 70, the numerous nanoparticles 50 contained in the thermoelectric material thin film 70 diffuse into each thermoelectric nanowire 90.

Further, as a result of observation of the TEM structure micrograph, it can be seen that numerous nanoparticles 50 are uniformly distributed in each thermoelectric nanowire 90 in a lengthwise direction.

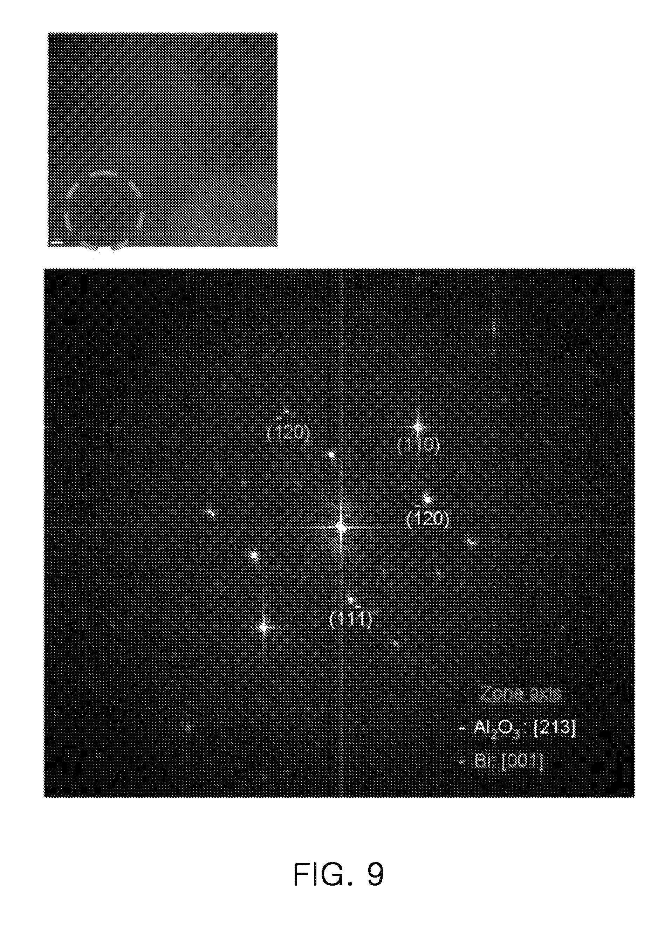

FIG. 9 is a micrograph showing the electron diffraction pattern of the single crystal thermoelectric nanowire manufactured in the Test Example of the present invention.

FIG. 9 (a) is a TEM structure micrograph of the thermoelectric nanowire according to the Test Example of the present invention, and FIG. 9(b) is a micrograph showing the electron diffraction pattern of part of this thermoelectric nanowire. This electron diffraction pattern shows that nanoparticles ($Al_2O_3$) are formed in a diamond structure. Further, it can be found that the thermoelectric materials (Bi) are formed in a single crystal having a rhombohedral structure. Further, it can be found from the electron diffraction pattern that no secondary phase, such as grains, is observed.

As described above, according to the present invention, to grow the single crystal thermoelectric nanowire, a typical nanowire synthesizing process, such as a template manufacturing process or a catalyst forming process, need not be carried out, unlike the prior art. Further, a single crystal thermoelectric nanowire having excellent crystallinity can be grown without introducing a starting material or a heterogeneous material and without a change in the state of the thermoelectric material. In addition, when this thermoelectric nanowire is grown, a plurality of nanoparticles capable of reducing thermal conductivity migrates into the thermoelectric nanowire, and thus a thermoelectric nanowire having excellent thermoelectric efficiency can be manufactured.

The present invention measures the electrical conductivity, thermal conductivity, and ZT of the single crystal thermoelectric nanowire to teach a new very-high-efficiency energy conversion mechanism, and thus it can form the basis of engineering applications. Further, the present invention suggests an important research direction for developing thermoelectric elements having very high conversion efficiency.

Further, the present invention secures a single crystal thermoelectric nanowire manufacturing technology and a nanoscale element application technology. These technologies can elevate the characteristics of existing elements to a higher level, and make possible the emergence of new elements, which implement various physical properties of material having nanoscale information that has yet to be discovered.

Further, the thermoelectric element using the thermoelectric nanowire of the present invention will serve as a motive for demonstrating a new method for the development of a new power generation system on the basis of the single crystal thermoelectric nanowire having a very-high-efficiency thermoelectric effect.

Furthermore, the use and application of the thermoelectric nanowire according to the present invention will add another dimension to development in various fields such as aerospace electric generators, heaters, aeronautical heat regulators, military infrared detectors, circuit coolers for missile guidance, constant temperature baths for medical equipment, blood storage devices, and so on.

The present invention may be summarized as follows: A thermoelectric nanowire and a method of manufacturing the same, in which an oxide layer and a thermoelectric material layer, both of which have different thermal expansion coefficients, are stacked on a substrate, and a single crystal thermoelectric nanowire is grown from a thermoelectric material using the compressive stress caused by the difference between the thermal expansion coefficients. The method includes preparing a substrate on which an oxide layer is formed, forming a plurality of nanoparticles, each of which includes aluminum (Al), silver (Ag), iron (Fe) or oxides thereof, on the oxide layer, forming a thermoelectric material thin film, which has thermoelectric properties, above the oxide layer so as to include the nanoparticles formed on the oxide layer, heat-treating the substrate having the thermoelectric material thin film to grow the thermoelectric nanowire containing the nanoparticles, and cooling the substrate at room temperature after the heat-treatment.

The foregoing descriptions of specific exemplary embodiments of the present invention have been presented for the purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the Claims appended hereto and their equivalents.

## Claims

1. A method of manufacturing a thermoelectric nanowire, the method comprising:

   preparing a substrate on which an oxide layer is formed;
   forming a plurality of nanoparticles on the oxide layer, each nanoparticle including aluminum (Al), silver (Ag), iron (Fe) or oxides thereof;
   forming a thermoelectric material thin film above the oxide layer so as to include the nanoparticles formed on the oxide layer, the thermoelectric material thin film having thermoelectric properties;
   heat-treating the substrate having the thermoelectric material thin film to grow the thermoelectric nanowire containing the nanoparticles; and
   cooling the substrate at room temperature after the heat-treatment.

2. The method as set forth in claim 1, wherein, in the heat-treatment, the substrate, the oxide layer, and the thermoelectric material thin film have different thermal expansion coefficients, and the thermoelectric material thin film, which undergoes high volume expansion, is subjected to compressive stress by the oxide layer, which undergoes low volume expansion.

3. The method as set forth in claim 2, wherein the thermoelectric nanowire is grown from the thermoelectric material thin film by the compressive stress while the nanoparticles on the oxide layer introduce thereinto.

4. The method as set forth in claim 2 and/or 3, wherein the thermal expansion coefficient of the thermoelectric material thin film has a difference of $2 \times 10^{-6}/°C$ to $20 \times 10^{-6}/°C$ when compared to that of the oxide layer, and is greater than that of the oxide layer.

5. The method as set forth in any one or more of claims 1 to 4, wherein the thermoelectric material has a composition that includes one selected from bismuth (Bi), a Bi-selenium (Se) alloy, a Bi-tellurium (Te) alloy, a lead (Pb)-Te alloy, a Bi-antimony (Sb) alloy, a Bi-Sb-Te alloy, and a Bi-Se-Te alloy.

6. The method as set forth in any one or more of claims 1 to 5, wherein, in the cooling, the substrate, the oxide layer, and the thermoelectric material thin film have different thermal expansion coefficients, and the thermoelectric material thin film, which undergoes high volume reduction, is subjected to tensile stress by the oxide layer, which undergoes low volume reduction.

7. The method as set forth in any one or more of claims 1 to 6, wherein the oxide layer has a composition that includes one selected from $SiO_2$, BeO, and $Mg_2Al_4Si_5O_{18}$, and has a thickness ranging from 3,000 Å to 5,000 Å.

8. The method as set forth in any one or more of claims 1 to 7, wherein the thermoelectric material thin film has a thickness ranging from 10 nm to 4 $\mu$m.

9. The method as set forth in any one or more of claims 1 to 8, wherein, in the heat-treatment, the substrate is heat-treated to a temperature ranging from 100°C to 1,000°C for a period ranging from 1 hour to 15 hours.

10. The method as set forth in any one or more of claims 1 to 9, wherein the thermoelectric nanowire has a single crystal structure and a diameter of 50 nm to 1,000 nm when grown.

11. The method as set forth in any one or more of claims 1 to 10, wherein each nanoparticle has a diameter ranging from 1 nm to 20 nm.

12. A thermoelectric nanowire manufactured by the method defined in any one or more of claims 1 to 11.

13. A thermoelectric nanowire element, comprising:

    a thermoelectric nanowire having a composition that includes one selected from Bi, a Bi-Se alloy, a Bi-Te alloy, a Pb-Te alloy, a Bi-Sb alloy, a Bi-Sb-Te alloy, and a Bi-Se-Te alloy; and
    a plurality of nanoparticles having a composition that includes Al, Ag, Fe or oxides thereof, the nanoparticles contained in the thermoelectric nanowire.

14. The thermoelectric nanowire element as set forth in claim 13, wherein the thermoelectric nanowire has a single crystal structure and a diameter ranging from 50 nm to 1,000 nm when grown.

15. The thermoelectric nanowire element as set forth in claim 13 and/or 14, wherein each nanoparticle has a diameter ranging from 1 nm to 20 nm.

FIG. 1

FIG. 2

FIG. 3

FIG. 4

Chamber

Si Substrate

Ar Gas

Bi Target

*(a)*

○ Bi atom    ○         ○ Bi atom

Ar Gas ○

*(b)*

FIG. 5

FIG. 6

FIG. 7

FIG. 8

FIG. 9

EP 2 224 505 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020092995
- KR 102006137069
- KR 10200751236